# EUROPEAN PATENT APPLICATION

(11) **EP 4 400 316 A1**
(43) Date of publication of application: **17.07.2024**
(21) Application number: 24150226.9
(22) Date of filing: 03.01.2024
(51) Int. Cl.: B41F 33/16, B41F 35/00, H05K 3/12, B08B 1/00, B08B 5/00

(54) **UNDERSCREEN CLEANING**

(30) Priority: 12.01.2023 GB 202300494
(71) Applicant: ASMPT SMT Singapore Pte. Ltd., Singapore 768924 (SG)
(72) Inventor: LELA, Rob, Illinois, IL 60169 (US); FOOT, George, St Leonards, BH24 2QZ (GB)
(74) Representative: Emerson, Peter James

(57) **Abstract**

A system (49) and a method of cleaning a printing screen with a cleaning head (3) movable across a surface of the printing screen, comprises using a vacuum source (50) connected to the cleaning head (3) via a flow line (52) to create a suction force, at the cleaning head (3), which is applied to the surface of the printing screen, and moving the cleaning head (3) across the surface of the printing screen, wherein the suction force applied to the surface is controlled dependent on determined print parameters.

## Description

This invention relates to a cleaning system, a printing machine, a method of cleaning and a computer program product.

### Background and Prior Art

Industrial screen-printing machines typically apply a conductive print medium, such as solder paste, silver paste or conductive ink, onto a planar workpiece, such as a circuit board, by applying the conductive print medium through a pattern of apertures in a thin planar layer or mask, such as a stencil (which is a patterned solid material such as stainless steel) or a screen which is a mesh material coated with emulsion. The present invention is particularly applicable to stencil printing, but has the potential to also be used with screens. For convenience, the term "screen" will be used to refer to any such patterned mask throughout the remainder of this document. The print medium is applied using an angled blade or squeegee. The same machines may also be used to print certain non-conductive media, such as glue or other adhesive, onto workpieces.

The printing screen is a substantially planar sheet which includes apertures which define the pattern to be printed. In one common form it comprises a screen sheet formed of metal or plastics material, while in another common form comprises a mesh comprising a flexible, perforate sheet, for example a woven mesh of polypropylene or stainless steel strands. In both forms it is necessary to hold the printing screen under tension, and normally this is achieved by gluing the screen to a rectangular frame while under this tension, or alternatively by attaching the printing screen to a quick change rectangular tensioning frame made for this purpose.

During printing operations, printing screens can rapidly become fouled with print medium. In particular, print medium can adhere to the underside of the printing screen, and, more problematically, adhere within apertures of the printing screen causing them to at least partially block and thus adversely affect print quality.

Printing machines are therefore typically provided with cleaning mechanisms to remove unwanted print medium and reduce aperture blockage. Printing machines produced by ASMPT for example are provided with underscreen cleaning systems, such as described for example in WO201114487 A1 and EP3482943 A1. These provide a cleaning module that performs a cleaning stroke in which it is caused to travel across the underside of a printing screen while it is located within a printing machine, and uses a combination of a porous cleaning material (in particular a length of cleaning fabric wetted with cleaning solvent), and a vacuum applied to the underside of the cleaning material. The vacuum has two main benefits - on the one hand it draws the printing screen downwardly on to the cleaning material as well as the cleaning head (described below) of the cleaning module, which helps to ensure a good contact therebetween, and on the other hand helps to dislodge print medium which is at least partially blocking an aperture of the printing screen. As a specific example, FIG. 1 reproduces an image from WO201114487 A1, and shows a printing machine 1 with an underscreen cleaning apparatus 2 used for cleaning the underside of a printing screen PS when mounted in the printing machine 1. The underscreen cleaning apparatus 2 comprises a cleaning head 3 which is operative to contact an underside of a printing screen PS, a feed unit 5 for feeding a cleaning sheet 7 to the cleaning head 3, an oscillator unit 8 for oscillating the cleaning head 3 over the surface of the printing screen PS (this unit being optional), a positioning unit 9 for raising and lowering the cleaning head 3 into and out of contact with the printing screen PS, and a support 11 to which the cleaning head 3 is supported and which is movable in a transport direction X over the underside of the printing screen PS to provide for cleaning of the same by a drive means, in this case a carriage 12 for an imaging camera (not shown) of the printing machine 1. The cleaning head 3 includes an elongate wiper 15 in the form of a wiper bar, which extends across a width of the printing screen PS. The wiper 15 includes a screen contact element 17 at an upper surface thereof which faces the underside of the printing screen PS and over which is provided a section of the cleaning sheet 7 whereby, when the cleaning head 3 is raised to a screen contact position, the screen contact element 17 contacts the underside of the printing screen PS. The screen contact element 17 has a first, screen drying section 17a which is configured to support a dry section of the cleaning sheet 7 thereabove, a second, vacuum section 17b, at which is vacuum or reduced pressure is applied to draw printing medium residue into the cleaning sheet 7 and cause the printing screen PS to be drawn onto the screen contact element 17 and thereby into firm, positive contact with the cleaning sheet 7, and a third, screen wetting section 17c which is configured to support a wet section of the cleaning sheet 7 thereabove. The vacuum section 17b of the screen contact element 17 includes a first elongate vacuum aperture 21 adjacent the screen drying section 17a of the screen contact element 17, a second elongate vacuum aperture 23 adjacent the screen wetting section 17c of the screen contact element 17 and an elongate support platform 25 disposed intermediate the vacuum apertures 21, 23. The wiper 15 comprises a vacuum manifold 27 which extends along the length of the wiper 15 and to which the vacuum section 17b of the screen contact element 17 and a vacuum source 28 such as a vacuum pump are fluidly connected by a flow line 48, whereby a vacuum is drawn through the length of the vacuum section 17b of the screen contact element 17 on operation of the vacuum source 28. The cleaning head 3 further comprises a fluid supply 31 which is operative to supply a cleaning fluid across a width of a section of the cleaning sheet 7. The fluid supply 31 comprises an elongate fluid supply member 33 which includes a plurality of fluid delivery outlets 35, arranged in spaced relation along a length thereof, for delivering a cleaning fluid across a width of a section of the cleaning sheet 7. The fluid supply member 33 includes a fluid supply manifold 37 which is a fluidly connected to the fluid delivery outlets 35 and a fluid source 38, such as a fluid pump, whereby operation of the fluid source 38 acts to deliver cleaning fluid from the delivery outlets 35 across a width of a section of the cleaning sheet 7. The feed unit 5 comprises a supply roll 41 of the cleaning sheet 7, a take-up roll 43 onto which used cleaning sheet 7 is wound, and a drive motor 45, which is operative to draw a predetermined length of the cleaning sheet 7 over the cleaning head 3. The supply roll 41 includes a drag mechanism 47 which provides a frictional torque against which the cleaning sheet 7 is drawn by the drive motor 45.

With this configuration, the cleaning head 3 provides for cleaning of the printing screen PS in a single sweep across the underside of the printing screen PS, with the screen wetting section 17c of the screen contact element 17 defining the leading edge of the cleaning head 3 and the screen drying section 17a of the screen contact element 17 defining the trailing edge of the cleaning head 3, whereby the underside of the printing screen PS is first wetted by a wet section of the cleaning sheet 7, subsequently wetted residue is drawn into the cleaning sheet 7 at the vacuum section 17b, with the vacuum simultaneously acting to draw the printing screen PS onto the screen contact element 17, and finally the underside of the cleaned printing screen PS is dried at the screen drying section 17a.

While such solutions work well, some problems have been observed. In particular, when the underscreen cleaner module is used to clean an area of a stencil with no or few apertures, the vacuum source, for example a pump, may be overworked, potentially affecting its lifespan. Furthermore, the cleaning performance will almost certainly vary across the stencil due to the wide range of aperture quantities and sizes that may be present on any given stencil image at any particular location.

The present invention seeks to address this problem. In particular, the inventors have realised that it is advantageous to vary the vacuum applied during a print operation. The present invention aims to provide means to maximise cleaning performance using such variable vacuum application. The present invention provides two distinct modes for achieving this: a first mode in which the suction force is varied during a cleaning stroke, in particular in dependence on the aperture pattern of the printing screen, and a second mode in which a suction force applied by the vacuum source is optimised for a particular printing screen and maintained constant for each cleaning stroke so that effective cleaning is ensured across the whole screen. The first mode may have particular utility for more responsive vacuum sources, while the second mode may have particular utility for less responsive vacuum sources.

### Summary of the Invention

In accordance with a first aspect of the present invention there is provided a cleaning system for cleaning a printing screen within a printing machine, the printing screen used in a print operation of the printing machine for printing print medium onto a succession of workpieces, the cleaning system comprising:
a cleaning head,
drive means for performing a cleaning stroke in which the cleaning head is moved across a surface of the printing screen,
a vacuum source for generating a vacuum or reduced pressure,
a flow line extending between the vacuum source and the cleaning head, for drawing air from the cleaning head to the vacuum source and thus transfer the vacuum or reduced pressure generated by the vacuum source to the cleaning head to generate a suction force at the cleaning head, and
a flow control means for adjusting the suction force generated at the cleaning head in dependence of print parameters determined in association with the print operation.

In accordance with a second aspect of the present invention there is provided a printing machine comprising the cleaning system of the first aspect.

In accordance with a third aspect of the present invention there is provided a method of cleaning a printing screen within a printing machine during a print operation of the printing machine for printing print medium onto a succession of workpieces,
the method comprising the steps of:
i) using a vacuum source connected to a cleaning head movable across a surface of the printing screen via a flow line to create a suction force, at the cleaning head, which is applied to the surface of the printing screen,
ii) performing a cleaning stroke by moving the cleaning head across the surface of the printing screen, and
iii) controlling the suction force applied to the surface dependent on print parameters determined in association with the print operation.

In accordance with a fourth aspect of the present invention there is provided a computer program product for controlling a control means to effect the method of the third aspect.

Other specific aspects and features of the present invention are set out in the accompanying claims.

### Brief Description of the Drawings

The invention will now be described with reference to the accompanying drawings (not to scale), in which:
FIG. 1 schematically shows, in a sectional side view, a known printing machine with an underscreen cleaning apparatus;
FIG. 2 schematically shows a cleaning system in accordance with an embodiment of the present invention;
FIGs. 3 shows a flow chart setting out how the cleaning system of FIG. 2 may be operated;
FIG. 4 schematically shows a typical variation of pressure applied to a printing screen by a pump running at a constant output speed, which may be constructed using the cleaning system of FIG. 2;
FIG. 5 schematically shows the pressure applied to a printing screen by a pump running at an optimised output speed, achievable using the cleaning system of FIG. 2; and
FIGs. 6 and 7 show flow charts setting out alternative methods of cleaning a printing screen in accordance with the present invention.

### Detailed Description of the Preferred Embodiments of the Invention

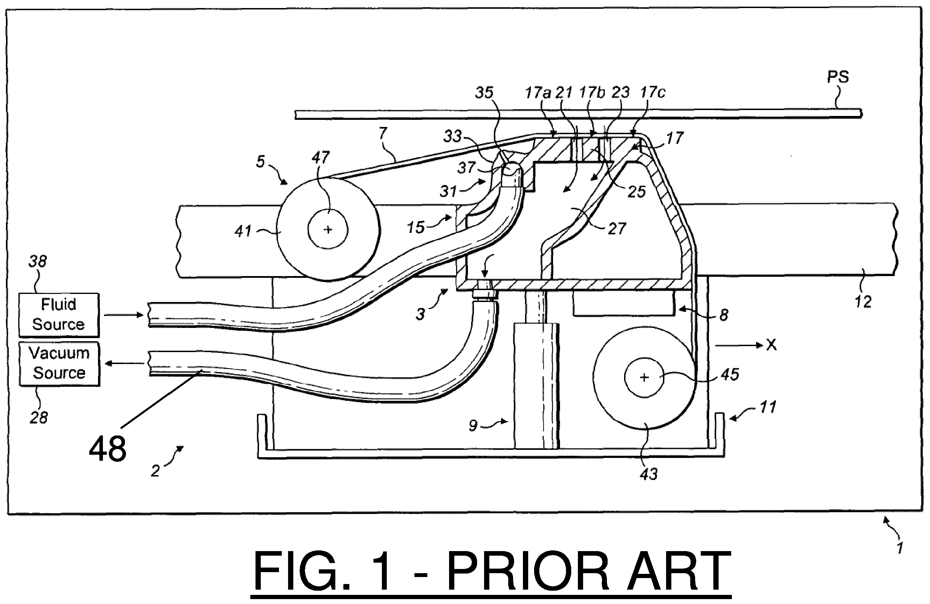

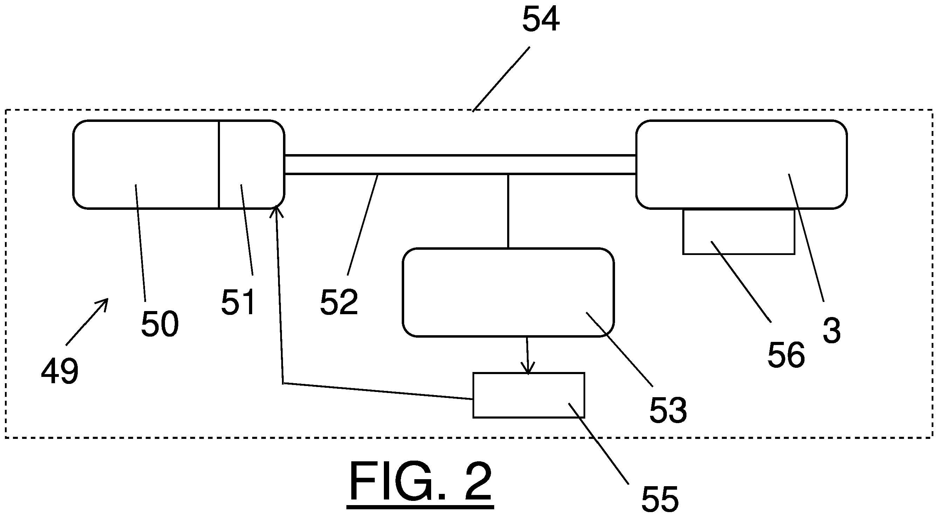

A cleaning system 49 according to an embodiment of the present invention, for cleaning a printing screen (not shown) within a printing machine 54 using the first mode outlined above, is schematically shown in FIG. 2. The cleaning system 49 includes a cleaning head 3, which could for the sake of example be identical or similar to that shown in FIG. 1. A drive means 56, such as a linear motor, rack and pinion arrangement, worm drive, rotating drive shaft or, as previously described with respect to FIG. 1, a carriage for another component of the printing machine 54, such as an imaging camera, is provided for moving the cleaning head 3 across a surface of the printing screen in a cleaning stroke in use. A vacuum source 50, such as a vacuum pump, is provided for generating a vacuum or reduced pressure. A flow line 52 extends between the vacuum source 50 and the cleaning head 3 for drawing air from the cleaning head 3 to the vacuum source 50 and thus transfer the vacuum or reduced pressure generated by the vacuum source 50 to the cleaning head 3 to generate a suction force at the cleaning head 3, as previously described with reference to FIG. 1. A sensor 53 is connected to the flow line 52, which is adapted to generate measurement data indicative of the instantaneous flow of air within the flow line 52 and pass the measurement data to a control system 55. Advantageously, the sensor 53 may comprise a flow meter for directly measuring the air flow rate in the flow line 52, however there are various other types of sensors which can generate such measurement data, such as pressure sensors, force meters and the like, which can indirectly indicate air flow within the flow line 52. The control system 55 may for example comprise not only a manual readout and / or control, but a computer, processor or other processing device. While in FIG. 2 it is shown wholly within the printing machine 54, in which case it may also control other aspects or the entire operation of the printing machine 54, it may also be located externally to the printing machine 54, for example at a central server or cloud location, and operative to control certain aspects or the entire operation of one or more printing machines and indeed optionally other modules within a surface-mount technology (SMT) production line. A flow control means 51 is provided for adjusting the suction force generated at the cleaning head 3 under the control of the control system 55.

In this embodiment, the flow control means 51 is able to control the vacuum source 50 to provide a highly responsive output power change. In a particularly simple arrangement, the vacuum source 50 and flow control means 51 are integrated as a responsive variable pump directly operative to generate different vacuums or reduced pressures during the travel of the cleaning head 3 across the printing screen, and the flow control means 51 is arranged to control the variable pump to adjust the suction force. Alternatively, the flow control means 51 may control the air pressure to the pump in order to vary the pump output. However, the flow control means 51 may be embodied in various different ways, for example the flow control means 51 may comprise a flow adjuster located in the flow line 52 between the vacuum source 50 and the cleaning head 3 to vary the suction force. As a particular example, such a flow adjuster may comprise a flow diverter to divert at least some of the flow of air away from the flow line 52, for example to a vent. Alternatively, the flow adjuster may comprise a flow restricter to restrict or throttle the flow of air in the flow line 52.

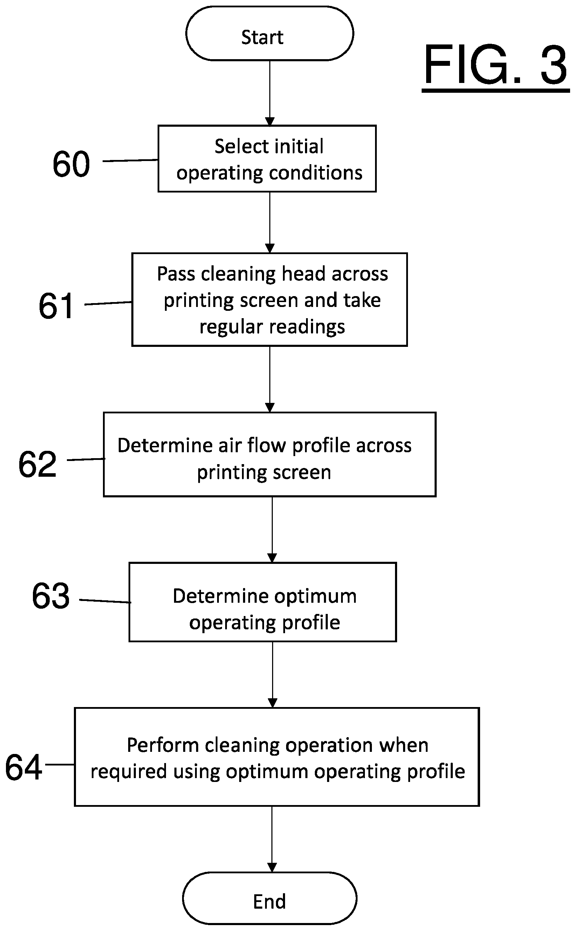

FIG. 3 shows a flow chart setting out a method of cleaning a printing screen in using the cleaning system of FIG. 2.

As shown in FIG. 3, in step 60, initial operating conditions for the printing and cleaning operations are selected. In particular, the operation conditions for the vacuum source 50 are selected for an initial pass of the cleaning head 3 across the printing screen. For example, if a variable pump is used as the vacuum source 50, an initial operating power (produced by an operating voltage typically between 0 and 10V) may be selected, and advantageously this will be kept constant throughout the next step, to create a suction force, at the cleaning head 3, which is applied to the surface of the printing screen.

In step 61, the cleaning head 3 is passed across a surface of the printing screen in a cleaning stroke and regular or continuous readings from the sensor 53 indicative of the instantaneous flow of air within the flow line 52 are taken during the cleaning stroke. This cleaning stroke may advantageously take place while the printing screen is clean, to avoid misleading readings being acquired due to partially blocked apertures. Advantageously, this initial cleaning stroke is performed before any printing operation has started.

In step 62, the readings are used to determine the air flow / suction force profile within the flow line 52 during the pass (it should be noted that since suction force is a function of air flow, these two parameters may be considered equivalent). Since the pump operating power is kept constant throughout the pass, any variation in the air flow profile will be produced by the aperture pattern of the printing screen, as will be described in more detail below. The measurements are either noted manually by sensor 53 and / or passed to the control system 55.

In step 63, the optimum operating profile for the vacuum source 50 is determined from the output of sensor 53 and / or by the control system 55. Typically, it is an aim to ensure a constant air flow across the printing screen, and so the optimum operating profile will be one that produces such constant air flow. Again, this will be described in more detail below.

In step 64, the optimum operating profile is used when performing further cleaning strokes, during an actual print operation, so that the suction force applied to the surface of the printing screen is controlled, by the control system 55, dependent on the pattern of apertures of the printing screen.

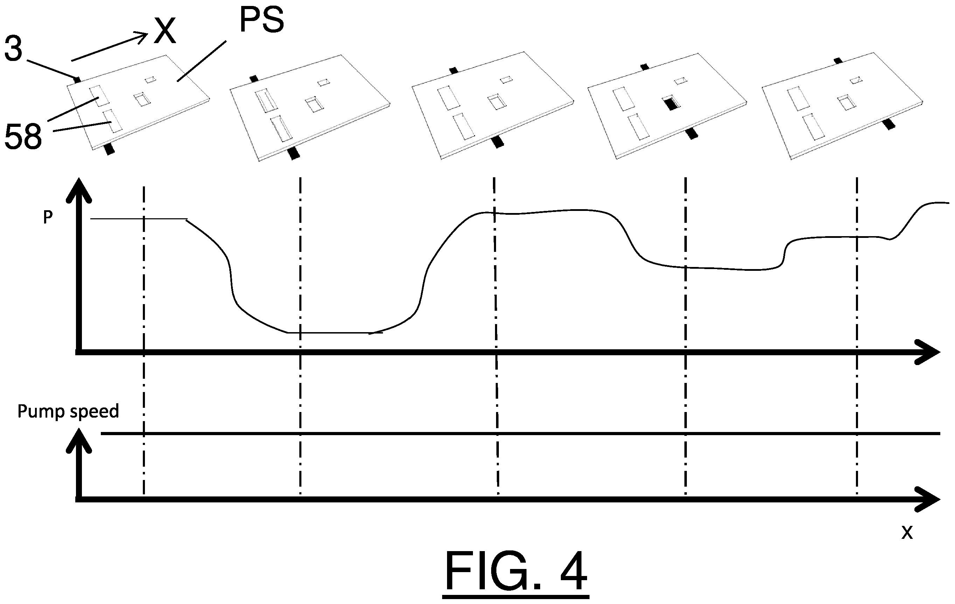

FIG. 4 schematically shows a typical variation of pressure applied to a printing screen PS by a vacuum source 50 such as a pump (not shown) running at a constant output speed, such as in the first pass performed in step 61 of FIG. 3 for example. The profile shown may be constructed using the cleaning system of FIG. 2. At the top of the figure is a series of images of the printing screen PS, each image taken at a different place along the path of travel of the cleaning head 3 in the transport direction X underneath the printing screen PS. The printing screen PS shown has a relatively simple pattern of apertures 58, with five apertures 58 being shown. The graph immediately underneath these images shows the pressure P applied to the printing screen PS as the cleaning head 3 performs a cleaning stroke, passing under the printing screen PS in transport direction X, which may readily be determined from the flow rate measurable in the flow line 52 by sensor 53. The final graph shows the output pump speed used during the cleaning stroke as the cleaning head 3 passes under the printing screen PS in transport direction X, and in this example the output pump speed is set to be constant.

It can be seen that when the cleaning head 3 underlies a region of the printing screen PS with no apertures present, the pressure applied to the printing screen PS is at a maximum. The pressure drops when the cleaning head 3 underlies a region of the printing screen PS with apertures present, with the pressure varying inversely with the total aperture area (i.e. the sum total of the area of each of the overlying apertures) in that region.

It should be noted that if, as is typically the case, the cleaning head 3 travels at a constant speed along transport direction X during the cleaning stroke, then similar plots using time t as the x-axis would appear equivalent to those shown.

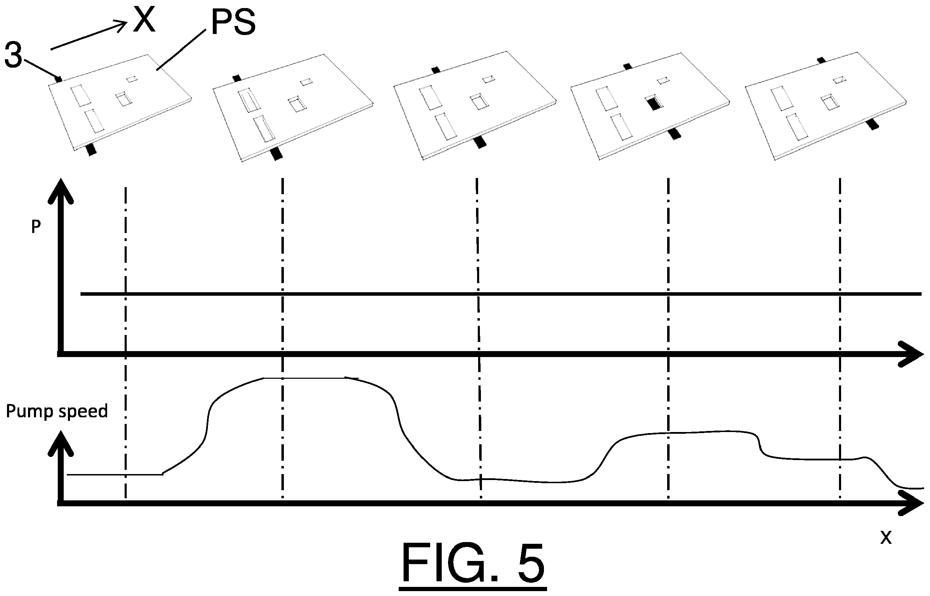

FIG. 5 schematically shows the pressure applied to a printing screen by a pump running at an optimised output speed, achievable using the cleaning system of FIG. 2, with the images and types of graphs shown being identical to those of FIG. 4.

As previously noted, it has been found optimal in many cases to apply a constant pressure to the printing screen PS throughout the range of travel of the cleaning head 3. As shown in FIG. 5, this may be achieved by controlling the pump speed to follow a profile that is effectively the inverse of the pressure profile obtained in FIG. 4.

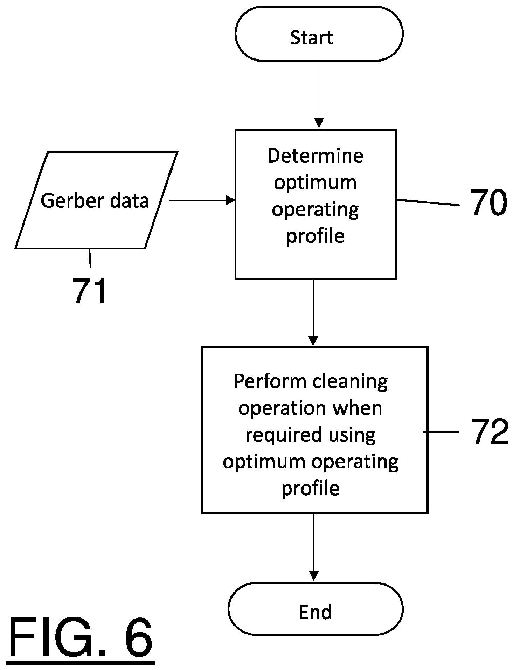

An alternative embodiment is shown in FIG. 6. As with the previous embodiment this enables operation according to the previously-described first mode, and so a relatively responsive vacuum source is preferred, but here no sensor is required. In step 70, an optimum operating profile for the vacuum source is determined. This involves analysis, by the control system, of Gerber-type data determined for the printing screen being used. The term "Gerber-type" as used herein means Gerber data, which is currently the industry standard data mechanism for characterising printing screen aperture patterns, and any equivalent data which provides such information on aperture patterns. In particular, here Gerber data 71 is analysed to assess the instantaneous aperture area or density which would be present in a region of the printing screen overlying the cleaning head during a pass across the surface of the printing screen. Generally, if there is a greater aperture area or density in the region overlying the cleaning head, then it is easier for air to flow within the flow line, thus increasing the flow rate within the flow line. Typically, it is an aim to ensure a constant air flow across the printing screen, and so the optimum operating profile will be one that produces such constant airflow. Therefore, the suction force applied to a region of the surface of the printing screen may be configured to be proportional to the aperture density or area within that region.

In step 72, the optimum operating profile is used when performing further cleaning operations, during an actual print run, so that the suction force applied to the surface of the printing screen is controlled, by the control system, dependent on the pattern of apertures of the printing screen.

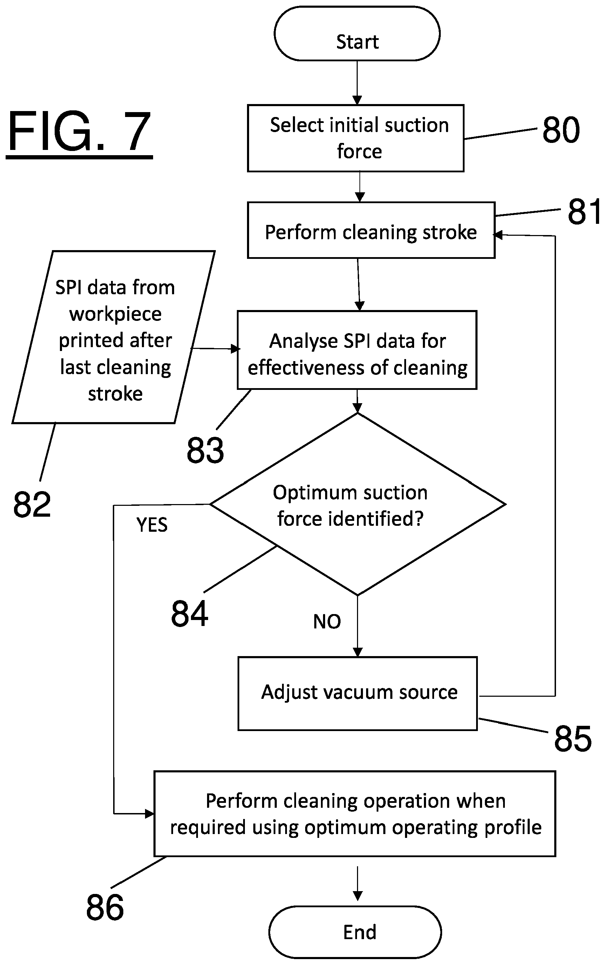

An alternative embodiment is shown in FIG. 7. Unlike the previously described embodiments, this methodology enables operation according to the previously-mentioned second mode, and so the vacuum source used need not be particularly responsive. In addition, no sensor is required for this embodiment, and so this methodology can optionally be utilised with less expensive equipment. In the second mode, rather than adjusting suction force throughout a cleaning stroke to provide an optimised profile, a single optimum suction force is determined for the printing screen.

It should be understood that printing of workpieces continues, without pause, throughout the following process. In step 80, an initial suction force is selected. As a simple example, if a variable pump is used as the vacuum source, it could be run at operating voltages in the range from, say, 1V to 10V, with the operating voltages being adjustable to incremental integer values, e.g. 1V, 2V, 3V ... 10V, with the suction force produced being a function of this operating voltage. Conveniently, an initial operating voltage may be chosen at one extreme of this range, say 10V. In step 81, a cleaning stroke is performed with the variable pump running at this initial operating voltage. The next workpiece to be printed following the cleaning stroke may then be analysed by an external inspection station, such as a solder paste inspection (SPI) machine as is well known in the art per se. The SPI machine is operative to optically inspect printed deposits on the workpiece, and assess these for quality. At 82, print parameters in the form of SPI data indicative of the quality of the printed deposits are obtained, and this is analysed in step 83 to determine the effectiveness of the cleaning stroke. In step 84, a decision is made as to whether the optimum suction force has been identified. This decision can be made by considering, for example:
- Is the determined cleaning effectiveness at a high enough standard to render further variation of the operating voltage unnecessary?
- Have all possible operating voltages been tested during respective cleaning strokes, so that the optimum voltage can be identified?

If the optimum suction force is not identified at 84, then the vacuum source is adjusted to a different level (in step 85), and the process returns to 81.

If the optimum suction force is identified at 84, then in step 86 future cleaning operations are performed using the identified optimum operating profile. The cleaning performance may be periodically checked using SPI data as before, and the vacuum source adjusted if necessary.

It is also possible to combine aspects of the first and second modes of operation. In such examples measurement data indicative of the instantaneous flow of air within the flow line may be measured using a sensor as described with reference to the first embodiment above, an operating profile determined from this measurement data, and SPI data for the printed workpieces again analysed to confirm whether the profile used provides acceptable cleaning performance, enabling further testing of alternative operating profiles as required.

The above-described embodiments are exemplary only, and other possibilities and alternatives within the scope of the invention will be apparent to those skilled in the art.

### Reference numerals used:

1 - Printing machine
2 - Underscreen cleaning apparatus
3 - Cleaning head
5 - Feed unit
7 - Cleaning sheet
8 - Oscillator unit
9 - Positioning unit
11 - Support
12 - Carriage
15 - Wiper
17 - Contact element
17a - Drying section
17b - Vacuum section
17c - Wetting section
21 - First vacuum aperture
23 - Second vacuum aperture
25 - Support platform
27 - Vacuum manifold
28 - Vacuum source
31 - Fluid supply
33 - Fluid supply member
35 - Fluid delivery outlets
37 - Fluid supply manifold
38 - Fluid source
41 - Supply roll
43 - Take-up roll
45 - Drive motor
47 - Drag mechanism
48 - Flow line
49 - Cleaning system
50 - Vacuum source
51 - Flow control means
52 - Flow line
53 - Sensor
54 - Printing machine
55 - Control system
56 - Drive means
58 - Apertures
60-82 - Flow chart steps
X - Transport direction
PS - Printing screen

## Claims

1. A cleaning system for cleaning a printing screen within a printing machine, the printing screen used in a print operation of the printing machine for printing print medium onto a succession of workpieces, the cleaning system comprising:
a cleaning head,
drive means for performing a cleaning stroke in which the cleaning head is moved across a surface of the printing screen,
a vacuum source for generating a vacuum or reduced pressure,
a flow line extending between the vacuum source and the cleaning head, for drawing air from the cleaning head to the vacuum source and thus transfer the vacuum or reduced pressure generated by the vacuum source to the cleaning head to generate a suction force at the cleaning head, and
a flow control means for adjusting the suction force generated at the cleaning head in dependence of print parameters determined in association with the print operation.

2. The cleaning system of claim 1, wherein the print parameters are determined from Gerber-type data associated with a pattern of apertures formed in the printing screen; alternatively the print parameters are determined by an inspection system operative to inspect a printed workpiece printed using the printing screen during the print operation; optionally the print parameters are indicative of the print quality of the printed workpiece.

3. The cleaning system of claim 1, comprising a sensor adapted to determine the print parameters, the print parameters comprising measurement data indicative of the instantaneous flow of air within the flow line; optionally the sensor comprises a flow meter for measuring the air flow rate in the flow line.

4. The cleaning system of any preceding claim, wherein the flow control means is operative to adjust the suction force generated at the cleaning head during a cleaning stroke, such that in use different regions of the printing screen are subjected to different suction forces as the cleaning head moves across the surface of the printing screen.

5. The cleaning system of any preceding claim, wherein the flow control means is operative to adjust the suction force generated at the cleaning head between successive cleaning strokes of the print operation.

6. The cleaning system of any preceding claim, wherein the vacuum source comprises a variable pump directly operative to generate different vacuums or reduced pressures, and the flow control means is arranged to control the variable pump to adjust the suction force.

7. The cleaning system of any of claims 1 to 5, wherein the flow control means comprises a flow adjuster located in the flow line between the vacuum source and the cleaning head to vary the suction force, the flow adjuster comprising one of a flow diverter to divert at least some of the flow of air away from the flow line or a flow restrictor to restrict the flow of air in the flow line.

8. A printing machine comprising the cleaning system of any preceding claim.

9. A method of cleaning a printing screen within a printing machine during a print operation of the printing machine for printing print medium onto a succession of workpieces,
the method comprising the steps of:
i) using a vacuum source connected to a cleaning head movable across a surface of the printing screen via a flow line to create a suction force, at the cleaning head, which is applied to the surface of the printing screen,
ii) performing a cleaning stroke by moving the cleaning head across the surface of the printing screen, and
iii) controlling the suction force applied to the surface dependent on print parameters determined in association with the print operation.

10. The method of claim 9, wherein the suction is controlled to change between two successive cleaning strokes.

11. The method of either of claims 9 and 10, wherein the suction is controlled to change during a cleaning stroke; optionally, during step iii), the suction force applied to the surface is controlled dependent on the pattern of apertures of the printing screen; optionally the suction force applied to a region of the surface of the printing screen is controlled to be proportional to the aperture density or area within that region.

12. The method of any of claims 9 to 11, comprising the steps:
generating measurement data indicative of the instantaneous flow of air within the flow line,
passing the measurement data to a control system, and
using the control system to control the suction force applied to the surface.

13. The method of any of claims 9 to 12, comprising an initial step of determining an optimum suction force profile for the printing screen, and wherein step iii) comprises controlling the suction force applied to the surface to follow the optimum suction force profile; optionally determining the optimum suction force profile comprises moving the cleaning head across the surface of the printing screen while applying a suction force to the surface of the printing screen,
determining print parameters comprising measurement data indicative of the instantaneous flow of air within the flow line, and
determining the optimum suction force profile from the measurement data; alternatively determining the optimum suction force profile comprises analysing Gerber-type data associated with the printing screen.

14. The method of any of claims 9 to 13, comprising analysing solder paste inspection data from at least one workpiece which has been printed using the printing screen, and during step ii), controlling the suction force applied to the surface dependent on the analysed solder paste inspection data.

15. A computer program product for controlling a control means to effect the method of any of claims 9 to 14.
